Europäisches Patentamt

European Patent Office

Office européen des brevets

(19)

(11) Publication number: **0 060 105**
**B1**

(12) **EUROPEAN PATENT SPECIFICATION**

(45) Date of publication of patent specification: **29.01.86**

(21) Application number: **82301133.3**

(22) Date of filing: **05.03.82**

(51) Int. Cl.⁴: **H 03 K 3/037**

(54) **Buffer circuit.**

(30) Priority: **05.03.81 JP 31752/81**

(43) Date of publication of application:
**15.09.82 Bulletin 82/37**

(45) Publication of the grant of the patent:
**29.01.86 Bulletin 86/05**

(84) Designated Contracting States:
**DE FR GB NL**

(56) References cited:
**GB-A-2 028 043**
**US-A-4 038 567**
**US-A-4 053 873**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**1-20-5-9-301, Utsukushigaoka Midori-ku**
**Yokohama-shi Kanagawa 227 (JP)**
Inventor: **Nozaki, Shigeki**
**473-4-203 Hisasue Takatsu-ku**
**Kawasaki-shi Kanagawa 213 (JP)**
Inventor: **Mezawa, Tsutomu**
**81, Aza Muranishi Oaza Tsuruga Ikki-machi**
**Aizuwakamatsu-shi Fukushima 965 (JP)**
Inventor: **Kabashima, Katsuhiko**
**407-1, Miyauchi Nakahara-ku**
**Kawasaki-shi Kanagawa 211 (JP)**
Inventor: **Enomoto, Seiji**
**3-16-403, Susukino-Danchi Midori-ku**
**Yokohama-shi Kanagawa 227 (JP)**

(74) Representative: **Abbott, Leonard Charles et al**
**GILL JENNINGS & EVERY 53-64 Chancery Lane**
**London WC2A 1HN (GB)**

Courier Press, Leamington Spa, England.

## Description

The present invention relates to a buffer circuit, more particularly, to a buffer circuit including a flip-flop which receives an external input and produces complementary outputs thereof.

The above-mentioned buffer circuit is currently used, for example, in the input stage, of data input circuits and the input stage of memory circuits as a so-called address buffer. The present invention, applicable to various other buffer circuit as well, will be explained with reference to address buffers.

Address buffers are incorporated into dynamic memories at their input stages so as to supply complementary addresses to decoders for accessing a desired memory cell in the memory. Such address buffers are mainly comprised of flip-flops provided with a pair of input/output terminals. The flip-flops receive an external address at one of the input terminals and produce complementary external addresses from the output terminals. An address buffer of this kind is described in US—A—4038567.

Currently used buffer circuits suffer from a defect in that the flip-flop cannot be changed to a stable state quickly since it is necessary to wait a certain time until the flip-flop is completely in its stable state, complementary external addresses cannot be produced in a short time. The reason for this will be clarified hereinafter. If such a buffer circuit is used as an address buffer in a dynamic memory, it would prevent the memory from operating at a high speed.

It is an object of the present invention to provide a buffer circuit which can overcome the above-mentioned defect and, therefore, which can produce complementary outputs in a short time.

A buffer circuit according to the invention is defined in Claim 1.

The present invention will be more apparent from the ensuing description of a known buffer circuit and of a preferred embodiment with reference to the accompanying drawings wherein:

Figure 1 illustrates a circuit diagram of a buffer circuit previously used by the applicants but not previously published;

Figure 2A is a timing diagram used for explaining the operation of the address buffer when an external address ADD of logic "L" is supplied thereto;

Figure 2B is a timing diagram used for explaining the operation of the address buffer when an external address ADD of logic "H" is supplied thereto;

Figure 3 illustrates one example of a circuit diagram of a buffer circuit according to the present invention; and

Figure 4 is a timing diagram used for explaining the operation of the address buffer shown in Figure 3.

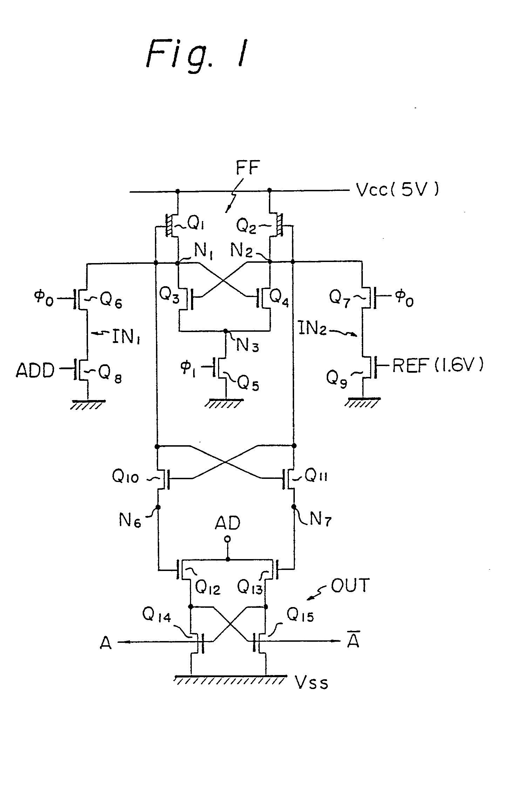

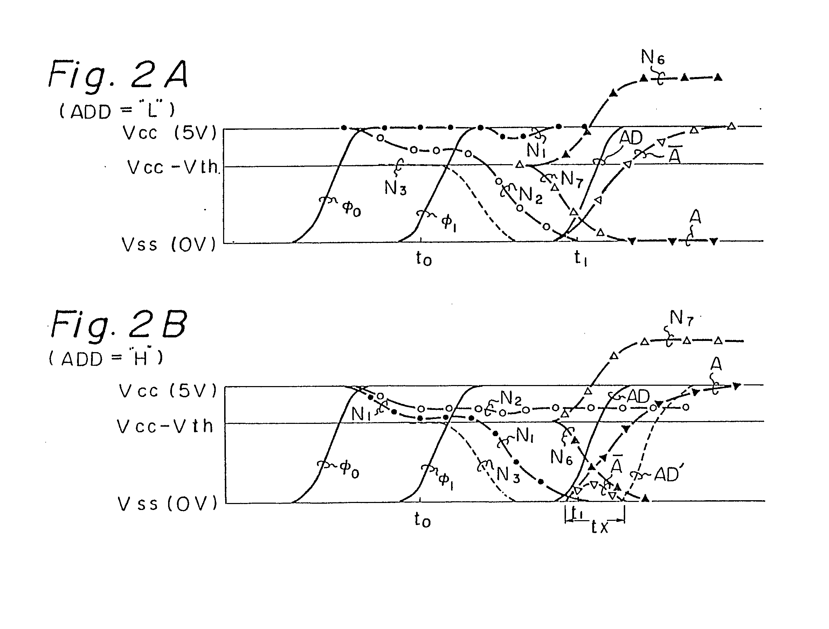

Figure 1 illustrates a circuit diagram of a buffer circuit previously used by the applicants. As previously mentioned, the buffer circuit will be explained in reference to an address buffer of a dynamic memory. The address buffer is comprised of a flip-flop FF, a first input circuit $IN_1$, a second input circuit $IN_2$, and an output circuit OUT. At the first input circuit $IN_1$, the address buffer receives an external address ADD and produces complementary outputs, that is, complementary addresses A and $\overline{A}$. If an external address ADD having logic "H" (high) is supplied, an address A of logic "H" and an inverted address $\overline{A}$ of logic "L" (low) are simultaneously produced and then transferred to the decoders of the memory. The external address ADD usually has a transistor-transistor logic (TTL) level of 2.4V as "H" and a TTL level of 0.8V as "L". The produced addresses A and $\overline{A}$ have a metal-oxide semiconductor (MOS) level of $V_{cc}$, such as 5V, as logic "H", and an MOS level of $V_{ss}$, such as 0V, as logic "L". The operations of the address buffer will be explained with reference to Figures 2A and 2B. The flip-flop FF is comprised of MOS transistors $Q_1$, $Q_2$ (both depletion MOS transistors), $Q_3$, and $Q_4$ so that it is formed as a main amplifier. The flip-flop FF includes therein a pair of input/output terminals at nodes $N_1$ and $N_2$. Node $N_1$ is coupled with the first input circuit $IN_1$, and node $N_2$ is coupled with the second input circuit $IN_2$. At the same time, nodes $N_1$ and $N_2$ are coupled with the output circuit. The first input circuit $IN_1$ is formed by an MOS transistor $Q_6$ for receiving, at its gate, a first clock $\phi_0$ for activating this first input circuit $IN_1$ (also the second input circuit $IN_2$) and an MOS transistor $Q_8$ for receiving, at its gate, the external address ADD. Both MOS transistors are connected in series. On the other hand, the second input circuit $IN_2$ is formed by an MOS transistor $Q_7$ for receiving, at its gate, the first clock $\phi_0$ and an MOS transistor $Q_9$ for receiving, at its gate, a reference voltage REF, such as 1.6V. Both MOS transistors are connected in series. The size of each of the transistors $Q_1$ through $Q_4$ and $Q_6$ through $Q_9$ is determined so as to form a symmetrical relationship, that is $SQ_1=SQ_2$, $SQ_3=SQ_4$, $SQ_6=SQ_7$, and $SQ_8=SQ_9$, wherein each symbol S denotes the sizes of transistors.

When the first clock $\phi_0$ for activating the first and second input circuits $IN_1$ and $IN_2$ is generated, the voltage levels $VN_1$ and $VN_2$ at the nodes $N_1$ and $N_2$ become slightly unbalanced due to the logic state of the external address ADD. If the logic state of the address ADD is "H" (or "L"), the inbalance may specifically be represented as

$$VN_1=2.4V>VN_2=1.6V$$

$$(or\ VN_1=0.8V<VN_2=1.6V).$$

The slightly unbalanced state is converted into a large unbalanced state when the flip-flop FF is activated. The flip-flop FF is activated when a second clock $\phi_1$ is generated. Clock $\phi_1$ makes an MOS transistor $Q_5$ conductive, thereby grounding a node $N_3$, which is common to each source of the

transistors $Q_3$ and $Q_4$. Thus, the flip-flop FF functions as the main amplifier in voltage.

Figure 2A is a timing diagram used for explaining the operation of the address buffer when an external address ADD of logic "L" is supplied thereto. Figure 2B is a timing diagram used for explaining the operation of the address buffer when an external address ADD of logic "H" is supplied thereto. Referring to Figures 1 and 2A, even though the first clock $\phi_0$ is generated, the voltage level $VN_1$ at the node $N_1$ is still maintained at nearly the level of $V_{cc}$, because the transistor $Q_8$ is turned OFF by the address ADD of logic "L". On the other hand, in the second input circuit $IN_2$, the transistor $Q_9$ is usually designed to be always conductive by the reference voltage REF (1.6V). Accordingly, when the first clock $\phi_0$ is generated and the transistor $Q_7$ is turned ON, a current starts flowing through the transistors $Q_2$, $Q_7$, and $Q_9$. Thus, the voltage level $VN_2$ at the node is changed to a certain level which is lower than the level $V_{cc}$ but higher than $(V_{cc}-V_{th})$, where the symbol $V_{th}$ denotes a threshold voltage level, and thereby the relationship $VN_1>VN_2$ is obtained. Under this condition, the second clock $\phi_1$ is then generated. As previously explained, the clock $\phi_1$ makes the transistor $Q_5$ conductive, and, therefore, the flip-flop FF is activated. Since now the relationship $VN_1>VN_2$ stands, the transistor $Q_3$ is turned OFF and at the same time the transistor $Q_4$ is turned ON. Thereafter, the voltage level $VN_1$ is kept at the level $V_{cc}$ while the voltage $VN_2$ is further reduced to the level $V_{ss}$, which means that the small voltage difference between the initial values of $VN_1$ and $VN_2$ is amplified by means of the flip-flop (main amplifier) FF.

Regarding nodes $N_6$ and $N_7$, the voltage levels $VN_6$ and $VN_7$ are initially precharged to the same level of $(V_{cc}-V_{th})$ via MOS gate transistors $Q_{10}$ and $Q_{11}$, respectively. However, since now the level $VN_1$ at the node $N_1$ is kept at the level $V_{cc}$ and the level $VN_2$ at the node $N_2$ is changed to the level $V_{ss}$, the gate transistor $Q_{10}$ is turned OFF and, at the same time, the gate transistor $Q_{11}$ is turned ON. Accordingly the electric charges at the node $N_7$ are discharged to the ground $(V_{ss})$ via the transistors $Q_{11}$, $Q_4$, and $Q_5$, and thus the voltage level $VN_7$ at the node $N_7$ is changed to the level $V_{ss}$. On the other hand, the electric charges at node $N_6$ remain as they are, because the gate transistor $Q_{10}$ is now cut off. However, next, the voltage level $VN_6$ is changed when a drive signal AD is generated. To be specific, when the drive signal AD having the level of $V_{cc}$ is supplied to an MOS transistor $Q_{12}$ (and also an MOS transistor $Q_{13}$), the voltage level $VN_6$ is increasingly shifted in level due to the creation of the so-called bootstrap effect caused by the presence of the transistor $Q_{12}$. Thus the voltage level at the node exceeds the level $V_{cc}$, as seen from the characteristic curve $N_6$ in Figure 2A. This causes an MOS transistor $Q_{15}$ to be conductive and, at the same time, an MOS transistor $Q_{14}$ to be nonconductive. Transistors $Q_{12}$ through $Q_{15}$ form the aforementioned output circuit OUT. As a result, the address A of the logic "L" having the level $V_{ss}$ and the inverted address $\bar{A}$ of logic "H" having the level $V_{cc}$ are produced from the output circuit OUT.

Contrary to the above, when an external address ADD having the logic "H" is supplied to the address buffer, the circuit of Figure 1 operates in accordance with the timing diagram shown in Figure 2B. It should be noted that the aforementioned defect is remarkably produced with the supply of an external address ADD of logic "H", but not logic "L". First, as mentioned above, the first clock $\phi_0$ is generated and, accordingly, the transistor $Q_6$ is turned ON. Also, the transistor $Q_8$ is turned ON by the address ADD of logic "H". In this case, since the gate voltage of the transistor $Q_8$, that is, 2.4V, is higher than that of the other transistor $Q_9$, that is, 1.6V, the relationship $VN_1<VN_2$ stands ($VN_1$ and $VN_2$ are the voltage levels at the nodes $N_1$ and $N_2$, respectively). The reason why the relationship $VN_1<VN_2$ stands is that the mutual conductance $g_m$ of the transistor $Q_8$ becomes larger than that of the transistor $Q_9$, because, generally, such mutual conductance varies large or small in accordance with a condition where such gate voltage is high or low, respectively.

Next, as previously explained, the second clock $\phi_1$ is generated, and, therefore, the flip-flop FF is activated. The voltage level $VN_1$ at the node $N_1$ is thereby reduced to the level $V_{ss}$. In this case, the voltage level $VN_2$ at the node $N_2$ is necessarily set to be higher than the level $VN_1$. However, it is important to note that the voltage level $VN_2$ is not the same or higher than the corresponding level $VN_1$ ($V_{cc}$) when the address ADD is logic "L" (compare the charactersitic curves $N_1$ in Figure 2A and $N_2$ in Figure 2B) and $\phi_0$ is applied. This is because, in the second input circuit $IN_2$, both transistors $Q_7$ and $Q_9$ are conductive after the first clock $\phi_1$ is generated (as previously mentioned the transistor $Q_9$ is normally made conductive). Therefore, the mutual conductance $g_m$ of the gate transistor $Q_{10}$ is relatively small as compared with that of the aforementioned gate transistor $Q_{11}$ during the supply of the address ADD having logic "L". Since the $g_m$ of the gate transistor $Q_{10}$ when ADD="H" is smaller than that of the gate transistor $Q_{11}$ when ADD="L", it takes a considerably long time to discharge completely the electric charges at the node $N_6$ to the ground ($V_{ss}$). In other words, residual electric charges exist for a while at the node $N_6$. Such residual electric charges cause the transistor $Q_{12}$ to be unnecessarily turned ON for a while after the drive signal AD is generated. Since the transistor $Q_{12}$ is unnecessarily turned ON for a while (see time $t_x$ in Figure 2B), an undesired level shift is produced in the address $\bar{A}$, although address $\bar{A}$ should be maintained at logic "L" ($V_{ss}$). The undesired level shift in the address $\bar{A}$ is illustrated as a mountain-shape characteristic curve $\bar{A}$ during the time $t_x$. In this case, there is no trouble regarding the level of the address A ($V_{cc}$). In the prior art, in order to eliminate such an undesired level shift from the

address $\bar{A}$, the drive signal AD must be generated with a certain time delay corresponding to time $t_x$, which delayed drive signal AD is depicted by dotted line characteristic curve AD' in Figure 2B. Such delay of time, however, causes the previously mentioned defect of preventing the memory from operating at a high speed.

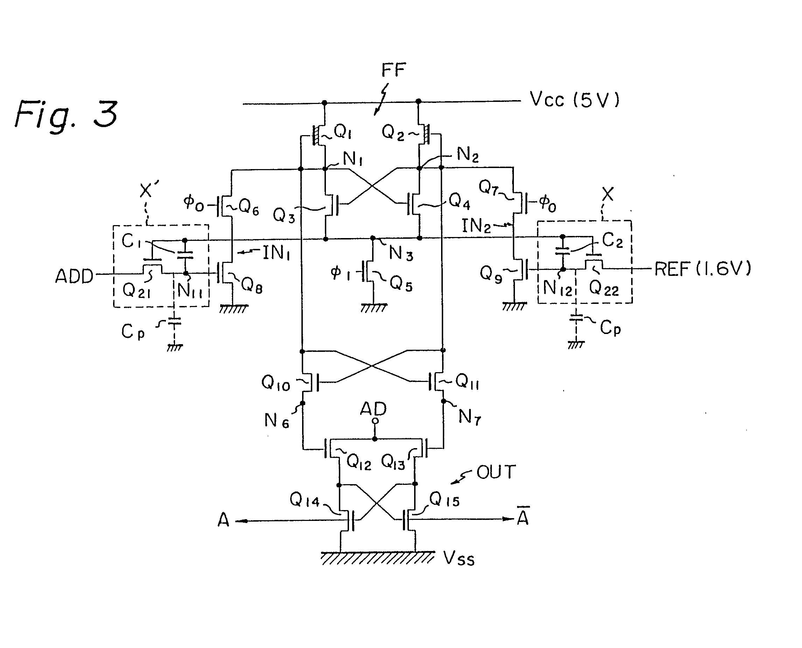

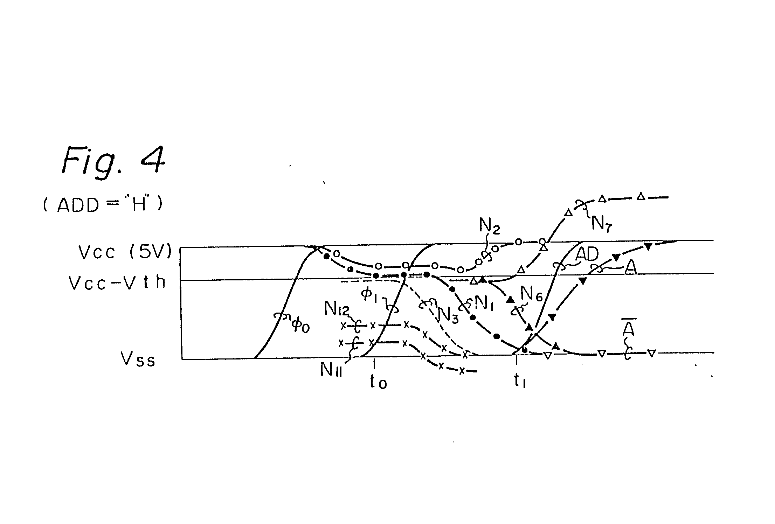

The present invention can overcome the above-mentioned defect by preventing the undesired level shift in the address A. Figure 3 illustrates one example of a circuit diagram of a buffer circuit according to the present invention. The buffer circuit is illustrated in reference to an address buffer, as in Figure 1. The members in Figure 4 identical to those in Figure 1 are referenced by the same reference symbols as in Figure 1. A level setting device X and a level setting device X' are newly employed. Although a pair of devices (X, X') is illustrated in Figure 3, the present invention is effective with just device X and without device X' in the address buffer. However in actual use, it is preferable to mount the same load (X, X') seen from each of the nodes $N_1$ and $N_2$ in view of circuit balance. The level setting device X functions to supply a certain voltage level so as to deactivate the second input circuit $IN_2$ during the activation of the flip-flop FF. The level setting device X' also functions identically to device X, during the activation of the flip-flop FF, with respect to the first input circuit $IN_1$. Prior to the activation of the flip-flop FF, these devices X and X' function to transfer, respectively, the reference voltage REF to the circuit $IN_2$ and the address ADD to the circuit $IN_1$. In the example of Figure 3, the level setting device X is comprised of an MOS transistor $Q_{22}$ and a capacitor $C_2$, while the level setting device X' is comprised of an MOS transistor $Q_{21}$ and a capacitor $C_1$. Each of these devices X and X' must be effective only during the activation of the flip-flop FF, that is, the generation of the second clock $\phi_1$. Therefore, in the example of Figure 3, each level setting device receives the voltage $VN_3$ at the node $N_3$ which is common to each source of the transistors $Q_3$ and $Q_4$. After the first clock $\phi_0$ is generated but before the second clock $\phi_1$ is generated, the address ADD of logic "H" is supplied to the transistor $Q_8$, at its gate, as in the buffer of Figure 1, but via the transistor $Q_{21}$ and a node $N_{11}$. This is true in the case where ADD="L". During the same time as mentioned above, the reference voltage REF is supplied to the transistor $Q_9$, at its gate, as in the buffer of Figure 1, but via the transistor $Q_{22}$ and a node $N_{12}$.

The above-mentioned construction is useful for eliminating the aforementioned undesired level shift in the address $\bar{A}$ (refer to the term $t_x$ in Figure 2B), especially when the external address ADD appears with the logic "H" but not "L". This will be clarified with reference to Figure 4.

Figure 4 is a timing diagram used for explaining the operation of the address buffer shown in Figure 3. The address ADD of logic "H" is supplied to the address buffer. Since the address ADD has a logic of "H", when the first clock $\phi_0$ is

generated, transistors $Q_6$ through $Q_9$ are all made conductive. Therefore, a current flows through the transistors $Q_1$, $Q_6$, and $Q_8$, and, at the same time, another current flows through the transistors $Q_2$, $Q_7$, and $Q_9$. In addition, the relationship $VN_1 < VN_2$ stands, because, as previously mentioned, the gate voltage (2.4V) of the transistor $Q_8$ is slightly higher than that of the transistor $Q_9$ (1.6V). Under such a condition, the second clock $\phi_1$ is next generated at a time $t_0$ (see Figure 4), and, accordingly, the transistor $Q_5$ is turned ON. Thus the flip-flop FF is activated and the transistors $Q_3$ and $Q_4$ are turned ON and OFF, respectively, in accordance with the relationship $VN_1 < VN_2$. Then, the voltage level $VN_1$ at the node $N_1$ is reduced to the level $V_{ss}$ via the transistors $Q_3$ and $Q_5$ (see the characteristic curve $N_1$ in Figure 4). The voltage level $VN_2$ at the node $N_2$ is maintained at a certain level slightly lower than the level $V_{cc}$ due to the current flow through the transistor $Q_9$ (see the characteristic curve $N_2$ before the time $t_0$ in Figure 4). Such reduction of the level $VN_2$ induces the aforementioned defect in the prior art. However, in the present invention, the level setting device X, compensates for such a reduction of the level $VN_2$. The operation for this is as follows. When the second clock $\phi_1$ is generated and the flip-flop FF starts being activated, the voltage level $VN_3$ at the node $N_3$ is reduced to the level $V_{ss}$. This level reduction at the node $N_3$ is fed back, via the capacitor $C_2$, to the node $N_{12}$. This level reduction is also introduced to the gate of the transistor $Q_{22}$ and makes it nonconductive. Therefore, the reference voltage REF is no longer supplied to the transistor $Q_9$. In this case, although the gate of the transistor $Q_9$ is completely isolated from the reference voltage REF, it is very likely to turn ON this transistor $Q_9$, due to the residual electrical charges stored in the parasitic capacitor $C_p$ neighboring the node $N_{12}$. Accordingly, a certain voltage is developed at the node $N_{12}$. Such certain voltage can be suppressed by the voltage level reduction at the node $N_3$, via the capacitor $C_2$. Thus the transistor $Q_9$ can completely be cut off. The above-mentioned level reduction at the node $N_{12}$ is depicted in Figure 4 as the characteristic curve $N_{12}$. Similarly, a level reduction at the node $N_{11}$ is depicted in this figure as the characteristic curve $N_{11}$. As a result, no current flows through the transistors $Q_2$, $Q_7$, and $Q_9$, unlike in the address buffer in Figure 1, and the voltage level $VN_2$ at the node $N_2$ can be pulled up to the level $V_{cc}$ (compare the characteristic curve $N_2$ after the time $t_0$ in Figure 4 with the corresponding curve $N_2$ in Figure 2B). Since the voltage level at the node $N_2$ is maintained at the level $V_{cc}$, and not a level between $V_{cc}$ and $(V_{cc} - V_{th})$, the mutual conductance $g_m$ of the transistor $Q_{10}$ shown in Figure 4 can be considerably increased as compared with that of the transistor $Q_{10}$ shown in Figure 1. This means that the electric charges at the node $N_6$ are discharged to the ground very quickly through the transistors $Q_{10}$ and $Q_3$. Thus, the mountain shape curve $\bar{A}$ during the time $t_x$ in Figure 2B no longer occurs.

Therefore, in Figure 2B, the generation of the drive signal AD can be made faster than prior art signal AD' by the time $t_x$. That is the drive signal AD can be generated at the time $t_1$ (refer to Figures 2B and 4). This is because, since the voltage level at the node $N_2$ is maintained at the highest level $V_{cc}$ after the time $t_0$, the transistor $Q_{12}$ can no longer be conductive at any time thereafter. Thus, the internal inverted address $\bar{A}$ can continuously be maintained at the level $V_{ss}$.

On the other hand, regarding the internal address A, although the first input circuit $IN_1$ is deactivated by the level setting device X', there is no trouble in producing the desired address A. This is because the first input circuit $IN_1$ is deactivated only during the activation of the flip-flop FF. Prior to this activation of the flip-flop FF, but after the generation of the first clock $\phi_0$, the voltage level at the node $N_1$ has already been determined at the level of nearly $(V_{cc}-V_{th})$. Therefore, after the second clock $\phi_1$ is generated, the voltage level at the node $N_1$ is reduced to the level of $V_{ss}$, even though the first input circuit $IN_1$ is deactivated by the device X'. In this case, the residual electric charges are left as they are at the node $N_7$, because the gate transistor $Q_{11}$ is turned OFF by the voltage level $VN_1$ equal to $V_{ss}$. The voltage level $VN_7$ is then pushed up, when the drive signal AD is generated, by the aforementioned bootstrap effect (refer to the characteristic curve $N_7$ in Figure 4). It should be noted that since the first and second input circuits $IN_1$ and $IN_2$ are deactivated by the devices X' and X, respectively, less power is consumed due to currents flowing through the circuits $IN_1$ and $IN_2$, especially during the activation of the flip-flop FF by the second clock $\phi_1$.

The operation of the address buffer in Figure 3 was explained in reference to the case where the external address ADD is logic "H", with reference to Figure 4. On the contrary, when an address ADD of logic "L" is supplied, the address buffer operates as if there were no such level setting devices X and X'. In this case, it should again be noted that the previously mentioned defect does not occur when the logic of the address ADD is "L" as opposed to "H". However, when ADD="L", it is still possible to reduce the power consumed by the circuits $IN_1$ and $IN_2$ during the activation of the flip-flop FF.

As explained hereinbefore in detail, the buffer circuit of the present invention is useful to realize a high operating speed. In addition, the buffer circuit of the present invention is advantageous in requiring lower power consumption.

**Claims**

1. A buffer circuit receiving external input (ADD) for producing internal complementary outputs (A, $\bar{A}$), comprising: a flip-flop (FF) provided with a first input/output terminal ($N_1$) and a second input/output terminal ($N_2$); a first input circuit ($IN_1$) coupled with the first input/output terminal for receiving the external input (ADD), the first input circuit being activated by a first clock signal ($\phi_0$); a second input circuit ($IN_2$) coupled with the second input/output terminal for receiving a reference voltage (REF), the second input circuit being activated by the first clock ($\phi_0$); and an output circuit coupled with the flip-flop (FF) via the input/output terminals ($N_1$, $N_2$) for producing the complementary outputs (A, $\bar{A}$) therefrom during activation of the flip-flop by a second clock ($\phi_1$); characterized in that the first input circuit ($IN_1$) includes first and second series-connected transistors, the first transistor ($Q_6$) being connected to the first input/output terminal and having a gate connected to receive the first clock signal ($\phi_0$), and the second transistor ($Q_8$) having a gate connected to receive the external input (ADD), the second input circuit ($IN_2$) includes third and fourth series-connected transistors, the third transistor ($Q_7$) being connected to the second input/output terminal and having a gate connected to receive the first clock signal ($\phi_0$) and the fourth transistor ($Q_9$) having a gate connected to receive the reference voltage (REF); and in that a level setting device (X) is coupled with the second input circuit ($IN_2$) for supplying such a voltage level as to de-activate the second input circuit during the activation of the flip-flop.

2. A buffer circuit as set forth in claim 1, further comprising another level setting device (X') coupled with the first input circuit ($IN_1$) for supplying such a voltage level as to de-activate the first input circuit during the activation of the flip-flop.

3. A buffer circuit as set forth in claim 1, wherein the level setting device (X) is comprised of a third transistor ($Q_{22}$) and a first capacitor ($C_2$), the gate of the third transistor ($Q_{22}$) is connected to a first terminal of the first capacitor, a second terminal of the first capacitor ($C_2$) is connected to the gate of the second transistor ($Q_9$) of the second input circuit and also to a source of the third transistor ($Q_{22}$) which receives, at its drain, the reference voltage, and the first terminal of the first capacitor receives a ground voltage level (at $N_3$) during the activation of the flip-flop.

4. A buffer circuit as set forth in claim 3, further comprising another level setting device (X') coupled with the first input circuit ($IN_1$) for supplying such a voltage level as to de-activate the first input circuit during the activation of the flip-flop, and wherein the other level setting device (X') is comprised of a fourth transistor ($Q_{21}$) and a second capacitor ($C_1$), the gate of the fourth transistor is connected to a first terminal of the second capacitor ($C_1$), a second terminal of the second capacitor is connected to the gate of the second transistor ($Q_8$) of the first input circuit and also to a source of the fourth transistor ($Q_{21}$) which receives, at its drain, the external input (ADD), and the first terminal of the second capacitor ($C_1$) receives a ground voltage level during the activation of the flip-flop.

5. A buffer circuit as set forth in claim 3 wherein the flip-flop (FF) is connected to a fifth transistor ($Q_5$) which is turned ON by the second clock ($\phi_1$)

and supplies the ground level to the flip-flop for activating it, the ground level being also applied (at N3) to the first terminal of the first capacitor (C2) via the fifth transistor.

6. A buffer circuit as set forth in claim 4, wherein the flip-flop is connected to a fifth transistor (Q5) which is turned ON by the second clock ($\phi_1$) and supplies the ground level to the flip-flop for activating it, the ground level being also applied to the first terminal of the first capacitor (C2) via the fifth transistor, and in addition the ground level being applied to the first terminal of the second capacitor (C1) via the fifth transistor.

## Patentansprüche

1. Pufferschaltung, die externe Eingänge (ADD) empfängt, um interne komplementäre Ausgänge (A, $\overline{A}$) zu erzeugen, mit:

einem Flip-flop (FF), welches einen ersten Eingangs/Ausgangs-Anschluß (N1) und einen zweiten Eingangs/Ausgangs-Anschluß (N2) aufweist;

einem ersten Eingangsschaltkreis (IN1), der mit dem ersten Eingangs/Ausgangs-Anschluß verbunden ist, um den externen Eingang (ADD) zu empfangen, und der durch ein erstes Taktsignal ($\phi_0$) aktiviert wird;

einem zweiten Eingangsschaltkreis (IN2), der mit dem zweiten Eingangs/Ausgangs-Anschluß gekoppelt ist, um eine Referenzspannung (REF) zu empfangen, und der durch den ersten Takt ($\phi_0$) aktiviert wird;

und einem Ausgangsschaltkreis, der mit dem Flip-flop (FF) über die Eingangs/Ausgangs-Anschlüsse (N1, N2) verbunden ist, um während der Aktivierung des Flip-flops durch einen zweiten Takt ($\phi_1$) komplementäre Ausgänge (A, $\overline{A}$) zu erzeugen;

dadurch gekennzeichnet, daß der erste Schaltkreis (IN1) erste und zweite in Reihe verbundene Transistoren umfaßt, von denen der erste Transistor (Q6) mit dem ersten Eingangs/Ausgangs-Anschluß verbunden ist und ein Gate hat, das zum Empfang des ersten Taktsignals ($\phi_0$) angeschlossen ist, und von denen der zweite Transistor (Q8) ein Gate hat, das zum Empfang des externen Eingangs (ADD) angeschlossen ist,

der zweite Eingangsschaltkreis (IN2) dritte und vierte in Reihe verbundene Transistoren umfaßt, von denen der dritte Transistor (Q7) mit dem zweiten Eingangs/Ausgangs-Anschluß verbunden ist und ein Gate hat, das zum Empfang des ersten Taktsignals ($\phi_0$) verbunden ist, und der vierte Transistor (Q9) ein Gate hat, das zum Empfang der Referenzspannung (REF) angeschlossen ist;

und daß eine Pegeleinstelleinrichtung (X) mit dem zweiten Eingangsschaltkreis (IN2) verbunden ist, um solch einen Spannungspegel zu liefern, um den zweiten Eingangsschaltkreis während der Aktivierung des Flip-flops zu de-aktivieren.

2. Pufferschaltung nach Anspruch 1, ferner mit einer weiteren Pegeleinstelleinrichtung (X'), die mit dem ersten Eingangsschaltkreis (IN1) gekoppelt ist, um solch einen Spannungspegel zuzuführen, um den ersten Schaltkreis während der Aktivierung des Flip-flops zu de-aktivieren.

3. Pufferschaltung nach Anspruch 1, bei welcher die Pegeleinstelleinrichtung (X) aus einem dritten Transistor (Q22) und einem ersten Kondensator (C2) besteht, das Gate des dritten Transistors (Q22) mit einem ersten Anschluß des ersten Kondensators verbunden ist, ein zweiter Anschluß des ersten Kondensators (C2) mit dem Gate des zweiten Transistors (Q9) des zweiten Eingangsschaltkreises und auch mit einer Source des dritten Transistors (Q22) verbunden ist, welcher, an seinem Drain, die Referenzspannung, empfängt, und der erste Anschluß des ersten Kondensators während der Aktivierung des Flip-flops einen Erdspannungspegel (bei N3) empfängt.

4. Pufferschaltung nach Anspruch 3, ferner mit einer anderen Pegeleinstelleinrichtung (X'), die mit dem ersten Eingangsschaltkreis (IN1) verbunden ist, um solch einen Spannungspegel zu liefern, um den ersten Eingangsschaltkreis während der Aktivierung des Flip-flops zu de-aktivieren, und bei welcher die andere Pegeleinstelleinrichtung (X') aus einem vierten Transistor (Q21) und einem zweiten Kondensator (C1) besteht, wobei das Gate des vierten Transistors mit einem ersten Anschluß des zweiten Kondensators (C1) verbunden ist, ein zweiter Anschluß des zweiten Kondensators mit dem Gate des zweiten Transistors (Q8) des ersten Eingangsschaltkreises und auch mit einer Source des vierten Transistors (Q21) verbunden ist, welcher, an seinem Drain, den externen Eingang (ADD) empfängt, und der erste Anschluß des zweiten Kondensators (C1) während der Aktivierung des Flip-flops einen Erdspannungspegel empfängt.

5. Pufferschaltung nach Anspruch 3, bei welcher das Flip-flop (FF) mit einem fünften Transistor (Q5) verbunden ist, welcher durch den zweiten Takt ($\phi_1$) eingeschaltet wird und Erdpegel an das Flip-flop liefert, um es zu aktivieren, wobei der Erdpegel auch (bei N3) dem ersten Anschluß des ersten Kondensators (C2) über den fünften Transistor zugeführt wird.

6. Pufferschaltung nach Anspruch 4, bei welcher das Flip-flop mit einem fünften Transistor (Q5) verbunden ist, welcher durch den zweiten Takt ($\phi_1$) eingeschaltet wird und Erdpegel an das Flip-flop liefert, um es zu aktivieren, wobei der Erdpegel auch dem ersten Anschluß des ersten Kondensators (C2) über den fünften Transistor zugeführt wird, und zusätzlich der Erdpegel über den fünften Transistor dem ersten Anschluß des zweiten Kondensators (C1) zugeführt wird.

## Revendications

1. Circuit tampon destiné à recevoir un signal d'entrée extérieur (ADD) pour produire des signaux de sortie complémentaires intérieurs (A, $\overline{A}$), comprenant: une bascule (FF) pourvue d'une première borne d'entrée/sortie (N$_1$) et d'une seconde borne d'entrée/sortie (N$_2$); un premier circuit d'entrée (IN$_1$) couplé à la première borne d'entrée/sortie pour recevoir le signal d'entrée extérieur (ADD), le premier circuit d'entrée étant rendu actif par un premier signal d'horloge ($\phi_0$); un second circuit d'entrée (IN$_2$) couplé à la seconde borne d'entrée/sortie pour recevoir une tension de référence (REF), le second circuit d'entrée étant rendu actif par le premier signal d'horloge ($\phi_0$); et un circuit de sortie couplé à la bascule (FF) pas les bornes d'entrée/sortie (N$_1$, N$_2$) pour produire les signaux de sortie complémentaires (A, $\overline{A}$) par celles-ci pendant que la bascule est rendue active par un second signal d'horloge ($\phi_1$); caractérisé en ce que le premier circuit d'entrée (IN$_1$) comprend des premier et second transistors connectés en série, le premier transistor (Q$_6$) étant connecté à la première borne d'entrée/sortie et comportant une grille connectée pour recevoir le premier signal d'horloge ($\phi_0$), et le second transistor (Q$_8$) comportant une grille connectée pour recevoir le signal d'entrée extérieur (ADD), en ce que le second circuit d'entrée (IN$_2$) comprend des troisième et quatrième transistors connectés en série, le troisième transistor (Q$_7$) étant connecté à la seconde borne d'entrée/sortie et comportant une grille connectée pour recevoir le premier signal d'horloge ($\phi_0$) et le quatrième transistor (Q$_9$) comportant une grille connectée pour recevoir la tension de référence (REF); et en ce qu'un dispositif de réglage de niveau (X) est couplé au second circuit d'entrée (IN$_2$) pour fournir ce niveau de tension de manière à rendre inactif le second circuit d'entrée pendant que la bascule est rendue active.

2. Circuit tampon selon la revendication 1, caractérisé en ce qu'il comprend en outre un autre dispositif de réglage de niveau (X') couplé au premier circuit d'entrée (IN$_1$) pour fournir ce niveau de tension de manière à rendre inactif le premier circuit d'entrée pendant que la bascule est rendue active.

3. Circuit tampon selon la revendication 1, caractérisé en ce que le dispositif de réglage de niveau (X) est constitué d'un troisième transistor (Q$_{22}$) et d'un premier condensateur (C$_2$), la grille du troisième transistor (Q$_{22}$) étant connectée à la première borne du premier condensateur, une seconde borne du premier condensateur (C$_2$) étant connectée à la grille du second transistor (Q$_9$) du second circuit d'entrée et également à une source du troisième transistor (Q$_{22}$) qui reçoit, par son drain, la tension de référence, et la première borne du premier condensateur recevant un niveau de tension de masse (en N$_3$) pendant que la bascule est rendue active.

4. Circuit tampon selon la revendication 3, caractérisé en ce qu'il comprend en outre un autre dispositif de réglage de niveau (X') couplé au premier circuit d'entrée (IN$_1$) pour fournir ce niveau de tension de manière à rendre inactif le premier circuit d'entrée pendant que la bascule est rendue active, et en ce que l'autre dispositif de réglage de niveau (X') est constitué d'un quatrième transistor (Q$_{21}$) et d'un second condensateur (C$_1$), la grille du quatrième transistor étant connectée à une première borne du second condensateur (C$_1$), une seconde borne du second condensateur étant connectée à la grille du second transistor (Q$_8$) du premier circuit d'entrée et également à une source de quatrième transistor (Q$_{21}$) qui reçoit, par son drain, le signal d'entrée extérieur (ADD), et la première borne du second condensateur (C$_1$) recevant un niveau de tension de masse pendant que la bascule est rendue active.

5. Circuit tampon selon la revendication 3, caractérisé en ce que la bascule (FF) est connectée à un cinquième transistor (Q$_5$) qui est rendu conducteur par le second signal d'horloge ($\phi_1$) et qui fournit le niveau de tension de masse à la bascule pour la rendre active, le niveau de tension de masse étant également appliqué (en N$_3$) à la première borne du premier condensateur (C$_2$) par l'intermédiaire du cinquième transistor.

6. Circuit tampon selon la revendication 4, caractérisé en ce que la bascule est connectée à un cinquième transistor (Q$_5$) qui est rendu conducteur par le second signal d'horloge ($\phi_1$) et qui fournit le niveau de tension de masse à la bascule pour la rendre active, le niveau de tension de masse étant également appliqué à la première borne du premier condensateur (C$_2$) par l'intermédiaire du cinquième transistor, et le niveau de tension de masse étant également appliqué à la première borne du second condensateur (C$_1$) par l'intermédiaire du cinquième transistor.

# Fig. 1

*Fig. 2A*
(ADD = "L")

Vcc (5V)

Vcc − Vth.

Vss (0V)

$N_6$, $AD$, $\overline{A}$, $A$, $N_1$, $N_2$, $N_7$, $N_3$, $\phi_1$, $\phi_0$, $t_0$, $t_1$

*Fig. 2B*
(ADD = "H")

Vcc (5V)

Vcc − Vth

Vss (0V)

$N_7$, $A$, $AD$, $\overline{A}$, $AD'$, $N_6$, $N_2$, $N_1$, $N_3$, $N_1$, $\phi_1$, $\phi_0$, $t_0$, $t_1$, $t_X$

Fig. 3

Fig. 4
( ADD = "H" )